## Europäisches Patentamt
## European Patent Office
## Office européen des brevets

(19)

(11) Veröffentlichungsnummer : **0 150 325**
B1

(12)

# EUROPÄISCHE PATENTSCHRIFT

(45) Veröffentlichungstag der Patentschrift :
20.09.89

(51) Int. Cl.⁴ : **H 03 K 5/135**

(21) Anmeldenummer : **84114396.9**

(22) Anmeldetag : **28.11.84**

(54) Verzögerungseinheit zur Erzeugung eines verzögerten Ausgangssignals.

(30) Priorität : **02.02.84 DE 3403637**

(43) Veröffentlichungstag der Anmeldung :
**07.08.85 Patentblatt 85/32**

(45) Bekanntmachung des Hinweises auf die Patenterteilung : **20.09.89 Patentblatt 89/38**

(84) Benannte Vertragsstaaten :
**DE FR GB IT NL**

(56) Entgegenhaltungen :
**EP–A– 0 086 305**
**FR–A– 2 092 967**
**GB–A– 2 036 496**

(73) Patentinhaber : **Siemens Aktiengesellschaft**
**Wittelsbacherplatz 2**
**D-8000 München 2 (DE)**

(72) Erfinder : **Dallmann, Achim, Dipl.-Phys.**
**Putzbrunner Strasse 18**
**D-8000 München 83 (DE)**

## Beschreibung

Die Erfindung betrifft eine Verzögerungseinheit zur Erzeugung eines gegenüber einem Eingangssignal um eine definierte Verzögerungszeit verzögerten Ausgangssignals, nach einer Veröffentlichung von A. Dallmann « Aufbau und Erprobung eines Mikroprozessor-gesteuerten Sampling-Systems für den Sub-Nano-sekundenbereich », Universität Düsseldorf aus dem Jahre 1982.

Zur Messung schneller elektrischer Signale, d. h. zur Bestimmung eines Spannungsverlaufs als Funktion der Zeit, können zum Teil nur Sampling-Verfahren, wie sie z. B. in Sampling-Oszillografen verwirklicht sind, verwendet werden. Dieses Meßprinzip, nämlich, einen Spannungsverlauf als Funktion der Zeit mit Hilfe eines Sampling-Verfahrens zu messen, wird z. B. auch zur Messung von internen Signalen bei integrierten Schaltkreisen angewandt. Dies geschieht beispielsweise mit Hilfe der Elektronenstrahlmeßtechnik in einem Raster-Elektronenmikroskop mit einer Ausrüstung für stroboskopische Potentialkontrastmessungen. Ein solches Elektronenstrahlmeßgerät ist beispielsweise in der US-Patentschrift 4 413 181 beschrieben. Für den Stroboskopbetrieb in einem solchen Elektronenstrahlmeßgerät wird eine Verzögerungseinheit zur Festlegung des Meßzeitpunkts mit sehr hoher Zeitgenauigkeit benötigt. Bei einem Elektronenstrahlmeßgerät soll eine solche Verzögerungseinheit darüber hinaus auch rechnersteuerbar sein und eine hohe Repetitionsrate beim Eintasten des Elektronenstrahles ermöglichen. Verzögerungseinheiten mit sehr hoher Zeitgenauigkeit, die eine hohe Repetitionsrate beim Messen von schnellen Signalen zulassen, werden in jedem Sampling-System benötigt.

Zur Darstellung des Spannungsverlaufs als Funktion der Zeit in zyklisch arbeitenden integrierten Schaltungen werden bei der Elektronenstrahlmeßtechnik stroboskopische Abbildungsverfahren verwendet. Dabei wird eine gepulste Elektronensonde synchron mit dem Zyklus des Spannungsverlaufs an einem Schaltungsknoten innerhalb einer integrierten Schaltung auf einen oder mehrere solcher Schaltungsknoten gerichtet. Dabei werden am Auftreffort der gepulsten Elektronensonde Sekundärelektronen ausgelöst. Diese Sekundärelektronen werden in einem Detektor nachgewiesen und liefern das Meßsignal. Soll nun ein größerer Bereich des zyklischen Spannungsverlaufs am Spannungsknoten innerhalb der integrierten Schaltung abgebildet werden, so muß der Einschaltzeitpunkt (die Phase) der Elektronensonde bezüglich des Zyklusbeginnes um definierte Beträge verschoben werden. Dieses Verschieben der Phase der Elektronensonde bezüglich eines zyklischen Spannungsverlaufs an einem Schaltungsknoten erfordert eine hohe Zeitgenauigkeit des Meßzeitpunkts, zu dem die gepulste Elektronensonde auf den Schaltungsknoten auftrifft. Für sehr hochfrequente Spannungsverläufe an solchen Schaltungsknoten wird eine hohe Repetitionsrate der Elektronensonde benötigt.

Bisher wird an Elektronenstrahlmeßgeräten ein Boxcar-Integrator, z. B. Model 162 der Fa. Princeton Applied Research, verwendet (siehe die bereits genannte US-Patentschrift Nr. 4 413 181), der die Phasenschiebung für die gepulste Elektronensonde und für die Meßsignalverarbeitung bezüglich des Spannungsverlaufs an einem Schaltungsknoten eines Meßobjekts über einen analogen Rampengenerator mit umschaltbarer Anstiegszeit und somit mit konstanter relativer Genauigkeit von 0,05 % erreicht. Dies bedeutet bei Verzögerungszeiten von 10 µs zwischen dem Eingangssignal der Verzögerungseinheit, beispielsweise dem Zyklusbeginn eines zyklischen Spannungsverlaufes, und dem Ausgangssignal, beispielsweise einem Signal zur Erzeugung eines Elektronenpulses bzw. einem Gate-Signal zur Verarbeitung eines Meßsignals, eine Genauigkeit der Verzögerungszeit bzw. eine Zeitauflösung von ca. 5 ns.

Bei Änderung des Meßbereiches muß bei Verwendung eines solchen Boxcar-Integrators von Hand an diesem Gerät umgeschaltet werden. Eine Rechnersteuerung ist daher bei Verwendung eines solchen Boxcar-Integrators nur bedingt, nämlich nur innerhalb jeweils eines einzigen Meßbereiches möglich. Die maximale Repetitionsrate eines solchen Boxcar-Integrators beträgt 2 MHz, wobei die Repetitionsrate durch die Verarbeitungsgeschwindigkeit im Gerät, speziell durch die Trigger-Aufbereitung und die Rampensteuerung, begrenzt ist.

Eine Genauigkeit einer Verzögerungszeit bzw. eine Zeitauflösung von ca. 5 ns und eine maximale Repetitionsrate von 2 MHz sind inzwischen für viele Anwendungsfälle bei der Elektronenstrahlmeßtechnik nicht mehr ausreichend.

Aus der Diplomarbeit « Aufbau und Erprobung eines Mikroprozessor-gesteuerten Sampling-Systems für den Sub-Nanosekunden-Bereich » von A. Dallmann, Universität Düsseldorf, DE, Oktober 1982, sind ein Verfahren und eine Verzögerungseinheit der eingangs genannten Art zur Erzeugung eines verzögerten Ausgangssignals bekannt. In einer Verzögerungseinheit nach dieser Diplomarbeit wird die Verzögerungszeit in groben Schritten von 20 ns durch Zählen eines 50-MHz-Quarz-signals eingestellt. Eine feinere Unterteilung der Verzögerungszeit wird durch ein schnelles Rampensignal mit einer Grenzauflösung von weniger als 0,5 ns erzielt. Bei einer Verzögerungseinheit nach dieser Diplomarbeit sind die Signale eines solchen Quarzgenerators, der eine ausreichende Frequenzstabilität aufweisen soll, nicht mit dem Eingangssignal synchronisierbar. Daher startet bei einer Verzögerungseinheit nach dieser Diplomarbeit das Eingangssignal zunächst den Ablauf des schnellen Rampensignals. Sodann wird dieser Ablauf des schnellen Rampensignals jedoch während einer vorgewählten Zählzeit eines 50-MHz-Zählers unterbrochen. Nach Ende dieser vorgewählten Zählzeit erreicht das schnelle Rampensignal schließlich eine vorgegebene Referenzspannung und löst dabei das verzögerte Ausgangssignal der Verzögerungseinheit aus. Die für das Rampensignal verwendete Referenzspannung kann von einem Rechner über einen Digital-/Analog-Wandler eingestellt werden. Die vorgewählte Zählzeit und die für das Rampensignal verwendete Referenzspannung können jedoch auch mit Hilfe einer anderen Vorrichtung, ohne Verwendung eines Rechners, vorgegeben werden.

Bei einer Verzögerungseinheit nach der genannten Diplomarbeit werden sowohl das Anlegen eines neuen Zählerstandes an den 50-MHz-Zähler als auch das Laden des jeweils neuen Zählerstandes sowie das Starten eines Betriebsmodus der Verzögerungseinheit, in dem das nächste ankommende Eingangssignal das nächste verzögerte Ausgangssignal auslöst, von einem Rechner gesteuert. Die Steuerung dieses Betriebsablaufs der Verzögerungseinheit zwischen zwei verzögerten Ausgangssignalen ist umfangreich und langwierig. Diese Steuerung des Betriebsablaufs durch den Rechner begrenzt die maximale Repetitionsrate der Verzögerungseinheit.

In der GB-A-2 036 496 « Pulse delay circuit » ist ebenfalls eine Verzögerungsschaltung angegeben, die eine Zählerstufe enthält. Durch einen Startimpuls am Eingang der Verzögerungsschaltung wird hierbei eine RC-Schaltung und über eine Flip-Flopstufe der Zähler angesteuert. Wie aus der betreffenden Beschreibung zu entnehmen ist, wird die Aufladung einer Kapazität in der RC-Schaltung durch den Zählvorgang in der Zählerstufe unterbrochen, wobei nach Beendigung des Zählvorganges der Aufladungsprozeß fortgesetzt wird. Schließlich wird zum Ende des Aufladungsvorganges über einen Pulsgenerator am Ausgang der Verzögerungsschaltung das gewünschte verzögerte Signal ausgelöst. Laut Angaben in der betreffenden Patentanmeldung gestattet diese Verzögerungsschaltung eine minimalste Verzögerungsezit von 100 ms. Dies ist jedoch für viele Anwendungsfälle in der Elektronenstrahlmeßtechnik ebenfalls nicht ausreichend.

Der vorliegenden Erfindung liegt die Aufgabe zugrunde, eine Verzögerungseinheit der eingangs genannten Art zur Erzeugung eines verzögerten Ausgangssignals anzugeben, die wesentlich höhere Repetitionsraten als nach dem Stand der Technik möglich zulassen.

Diese Aufgabe wird erfindungsgemäß durch eine Verzögerungseinheit nach dem Anspruch 1 gelöst. Ausgestaltungen und Vorteile der Erfindung sind in der Beschreibung und in der Zeichnung dargestellt.

Bei einer erfindungsgemäßen Verzögerungseinheit wird nach jedem verzögerten Ausgangssignal ein neuer, vorgewählter Zählerstand automatisch, d.h. unabhängig von einem Rechner, in einen Zählbaustein gelaben. Auf diese Weise werden beispielsweise Repetitionsraten von 20 MHz ermöglicht. Eine erfindungsgemäße Verzögerungseinheit genügt damit beispielsweise den Erfordernissen, die in der Elektronenstrahlmeßtechnik an ein solches Verfahren und an eine solche Verzögerungseinheit gestellt werden. Die erfindungsgemäße Verzögerungseinheit kann auch bei anderen Meßsystemen außerhalb der Elektronenstrahlmeßtechnik zur Analyse von schnellen Signalen überall dort eingesetzt werden, wo eine hohe Repetitionsrate benötigt oder vorteilhaft ist.

Eine erfindungsgemäße Verzögerungseinheit ermöglicht eine konstante absolute Zeitgenauigkeit von 0,5 ns sowohl bei kurzen als auch bei langen Verzögerungszeiten. Darüber hinaus ermöglicht die erfindungsgemäß Verzögerungseinheit eine minimale Verzögerungszeit von ca. 15 ns zwischen Signaleingang und Signalausgang. Bei vielen Meßsystemen ist es vorteilhaft, wenn sie von einem Rechner gesteuert werden können. Die erfindungsgemäße Verzögerungseinheit ermöglicht eine einfache Steuerung über einen Rechner.

Ausführungsbeispiele der Erfindung sind in der Zeichnung dargestellt und werden im folgenden näher erläutert.

Fig. 1 zeigt ein Blockschaltbild einer erfindungsgemäßen Verzögerungseinheit.

Fig. 2 zeigt ein Signaldiagramm für ein Verfahren und für eine Verzögerungseinheit nach der Erfindung.

Fig. 3 zeigt ein Ausführungsbeispiel für eine Verzögerungseinheit nach der Erfindung.

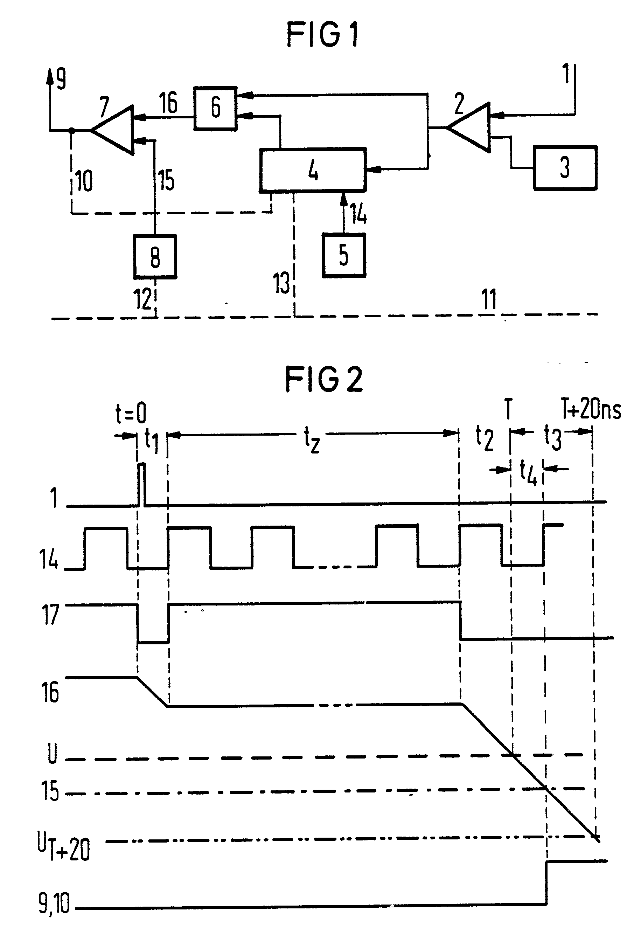

Fig. 1 zeigt eine Verzögerungseinheit nach der Erfindung. Das Eingangssignal (Trigger) 1 trifft auf einen Eingang eines Komparators 2, an dessen zweitem Eingang eine Triggerschwelle 3 anliegt. Sobald der Ausgang dieses Komparators 2 von einem Eingangssignal 1 auf einen bestimmten Spannungspegel eingestellt worden ist, wird dieser Ausgang des Komparators 2 verriegelt, so daß dieses Ausgangssignal des Komparators 2 auch nach Abklingen desjenigen Eingangssignals 1, das die Einstellung dieses Ausgangssignals des Komparators 2 auf einen bestimmten Spannungspegel verursacht hat, erhalten bleibt. Das Ausgangssignal des Komparators 2 ist mit einem 50-MHz-Vorwahlzähler 4 so verbunden, daß dieser Vorwahlzähler 4 von dem Ausgangssignal des Komparators 2 dazu veranlaßt werden kann, von einem eingestellten Zählerstand nach Null zu zählen. Der voreingestellte Zählerstand an diesem Vorwahlzähler 4 wird von einem Rechner über einen MPU-Bus 11 und weiter über Signalleitungen 13 zwischen dem Bus 11 und dem Vorwahlzähler 4 vorgeben. Ein 50-MHz-Generator 5 gibt den Takt vor, in dem der 50-MHz-Vorwahlzähler 4 von dem voreingestellten Zählerstand nach Null zählt.

Das Ausgangssignal des Komparators 2 und das Ausgangssignal des Vorwahlzählers 4 werden zum Steuersignal eines Rampengenerators 6 zusammengefügt. Das Ausgangssignal 16 des Rampengenerators 6 wird in einem weiteren Komparator 7 mit einer Referenzspannung 15 verglichen. Die Größe der Referenzspannung 15 kann wiederum von einem Rechner über den MPU-Bus 11 über Signalleitungen 12 zwischen diesem Bus und einem Digital-/Analog-Wandler 8 und weiter über diesen Digital-/Analog-Wandler 8 vorgegeben werden. Am Ausgang des Komparators 7 erscheint das verzögerte Ausgangssignal 9. Dieses verzögerte Ausgangssignal 9 wird über eine Signalleitung 10 zum Vorwahlzähler 4 zurückgeführt.

Fig. 2 zeigt ein Signaldiagramm für eine Verzögerungseinheit nach der Erfindung. Das Eingangssignal 1 zeigt eine positive Flanke zum Zeitpunkt t = 0. Das Ausgangssignal 14 des Quarzgenerators 5 ist phasenmäßig mit dem Eintreffen des Eingangssignals 1 nicht korreliert. Die positive Flanke des Eingangssignals 1 startet über das Steuersignal 17, das in diesem Fall vom Ausgang des Komparators 2 gebildet wird, den Ablauf des Rampensignals 16. Sobald nach Eintreffen des Eingangssignals 1 die erste positive Flanke des Quarzsignals 14 auftritt, wird über einen Ausgang des Vorwahlzählers 4 das Steuersignal 17 auf Eins gesetzt und der Ablauf des Rampensignals 16 unterbrochen, so daß das Rampensignal 16 zunächst denjenigen Wert beibehält, den es bei Auftreten der ersten positiven Flanke des Quarzsignals 14 nach Eintreffen des Eingangssignals 1 aufgewiesen hat.

Mit Auftreten der ersten positiven Flanke des Quarzsignals 14 nach Eintreffen des Eingangssignals 1 wird der programmierbare Vorwahlzähler 4 freigegeben, der vom eingestellten Zählerstand nach Null zählt. Der Takt für dieses Zählen vom eingestellten Zählerstand nach Null wird vom Quarzsignal 14 gebildet. Die Zählzeit des Vorwahlzählers 4 beträgt dabei $t_z$. Wird das Quarzsignal 14 von einem 50-MHz-Generator 5 erzeugt, so beträgt der zeitliche Abstand zwischen zwei Pulsen dieses Quarzsignals 14 20 ns. Umfaßt der voreingestellte Zählerstand im Vorwahlzähler 4 n Takte des Quarzsignals 14, so beträgt die Zählzeit $t_z$ n.20 ns. Nach Ablauf der Zählzeit $t_z$ des Vorwahlzählers 4 wird die Unterbrechung des Rampensignals 16 aufgehoben. Nach einer Zeit T erreicht das Rampensignal 16 eine Spannung U, die so gewählt ist, daß die Summe der Zeiten $t_1$ und $t_2$, zu denen das Rampensignal 16 sich so weit verändert hat, daß es diese Spannung U erreicht hat, gerade 20 ns, das ist die Dauer eines Taktes des Quarzsignals 14, beträgt. Nach Ablauf der Zeit T verändert sich das Rampensignal 16 über einen weiteren Zeitraum $t_4$ weiterhin so, daß es zum Zeitpunkt $T + t_4$ den Wert der Referenzspannung 15 erreicht. Sobald das Rampensignal 16 diesen Wert der Referenzspannung 15 erreicht, wird das verzögerte Ausgangssignal 9 ausgelöst. Dieses verzögerte Ausgangssignal 9 wird gleichzeitig als Signal 10 zum Vorwahlzähler 4 zurückgeleitet, wo dieses Signal 10 das Laden eines neuen Zählerstandes unabhängig vom Rechner in den Vorwahlzähler 4 veranlaßt.

Der Wert der Referenzspannung 15 befindet sich zwischen der Spannung U und einer Spannung $U_{T+20}$. Diese Spannung $U_{T+20}$ würde vom Rampensignal 16 nach Ablauf einer Zeit T + 20 ns erreicht werden. Das Rampensignal 16 erreicht unabhängig von der Phasenlage des Quarzsignals 14 bezüglich der Phasenlage des Eingangssignals 1 und unabhängig vom Zählerstand n des Vorwahlzählers 4 zur Zeit T den Wert U. Im Zeitintervall zwischen der Zeit T und der Zeit T + 20 ns geschieht die Feinaufteilung der Gesamtverzögerungszeit. Daher muß die Referenzspannung 15 zwischen der Spannung U zur Zeit T und der Spannung U zur Zeit T + 20 ns liegen.

Für Verzögerungszeiten kleiner als 40 ns kann die Zählmethode nicht verwendet werden. Für Verzögerungszeiten kleiner als 40 ns wird der Zähler abgeschaltet und eine rein analoge Verzögerung durchgeführt. Dabei wird von der positiven Flanke des Eingangssignals 1 über den Ausgang des Komparators 2 der Ablauf des Rampensignals 16 gestartet. Dieses Rampensignal 16 läuft sodann ohne Unterbrechung solange ab, bis der Wert des Rampensignals 16 den Wert Referenzspannung 15 erreicht und dabei das verzögerte Ausgangssignal 9 auslöst.

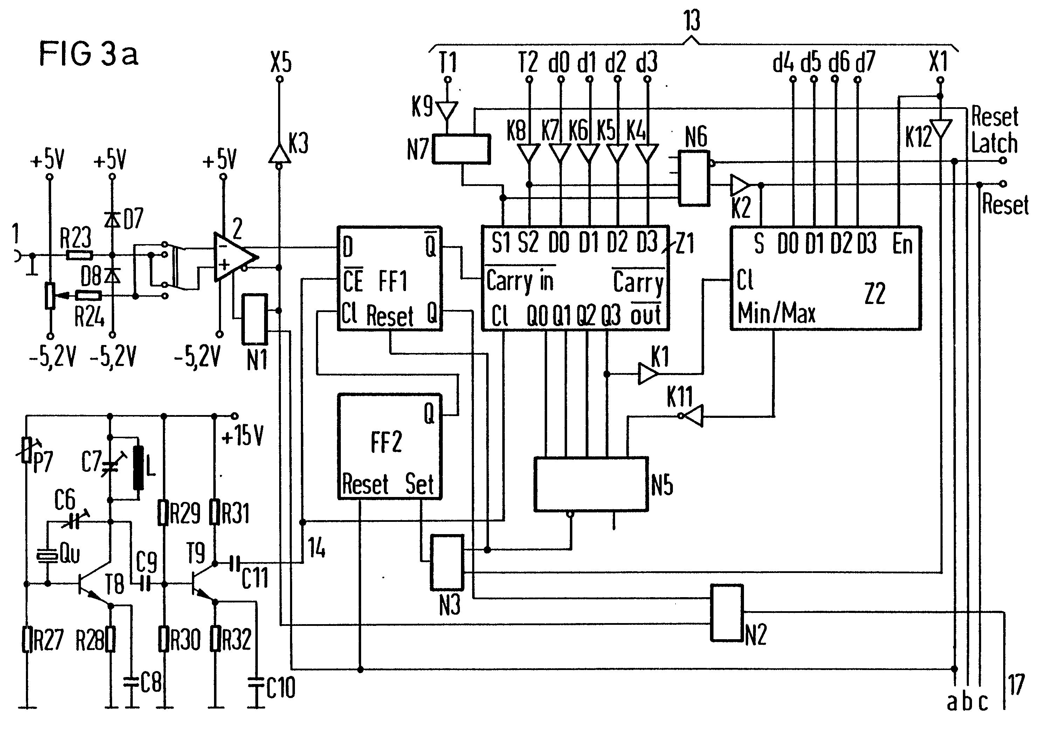

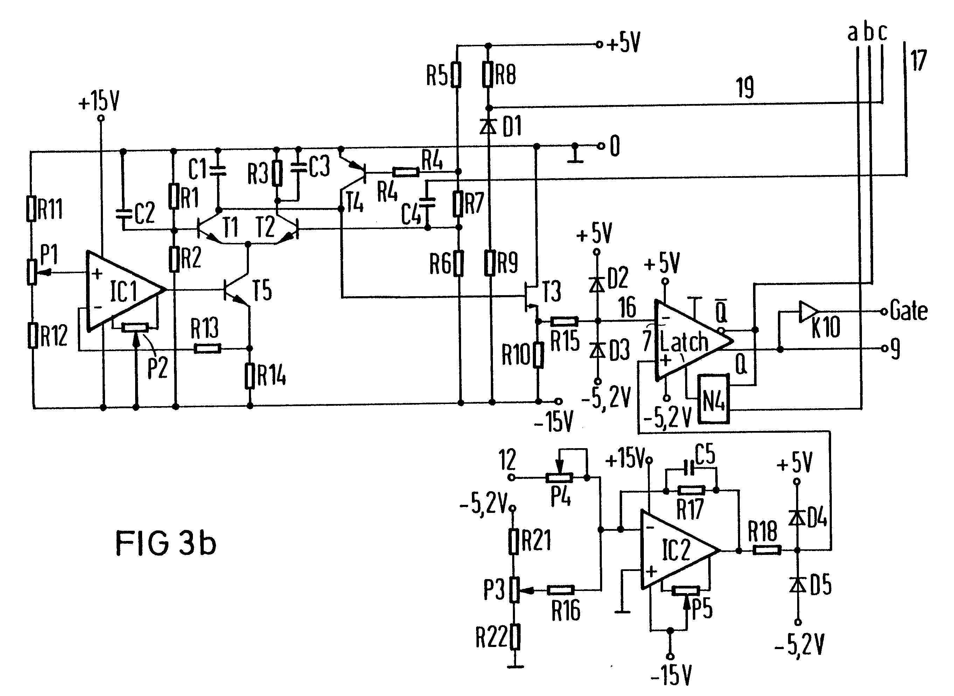

Fig. 3 zeigt ein Ausführungsbeispiel für eine Verzögerungseinheit nach der Erfindung. In einer Schaltung für eine erfindungsgemäße Verzögerungseinheit müssen möglichst kurze Anstiegszeiten und Verzögerungszeiten bzw. Jitter erzielt werden können. Dabei ist forgendes zu beachten : Bei hochohmigem Aufbau können schon durch nahezu unvermeidbare Leitungskapazitäten von einigen pF längere Aufladezeiten auftreten. Beispielsweise beträgt die Zeitkonstante, die als das Produkt von Widerstand und Kapazität angegeben werden kann, 20 ns bei einem Widerstand von 1 kOhm und einer Kapazität von 20 pF. Weiter muß der Aufbau der Schaltung für eine erfindungsgemäße Verzögerungseinheit möglichst niederinduktiv erfolgen. Bauteile mit hohen induktiven Komponenten, wie z. B. Drahtwiderstände oder Elektrolytkondensatoren, dürfen in kritischen Baugruppen nicht verwendet werden. Darüber hinaus müssen die verwendeten Halbleiter geringe Sperrschichtkapazitäten und hohe Grenzfrequenzen und somit kurze Anstiegszeiten aufweisen. Die Anforderungen, die aus diesen Gründen an Dioden und Transistoren zu stellen sind, werden jedoch bereits von einfachen Bautypen, wie z. B. 1 N 914, BC 237, BC 307 usw., erfüllt. Mit solch einfachen Bautypen können bereits Schaltzeiten von 2-3 ns erreicht werden.

Bei der Schaltungskonzeption ist weiterhin folgendes zu beachten : Beim Umschalten eines pn-Übergangs vom gesperrten in den leitenden Zustand tritt nur eine kurze Verzögerung ein. Anders ist es beim Übergang vom leitenden in den gesperrten Zustand. Dabei müssen zum einen die freien Ladungsträger aus der Sperrschicht ausgeräumt werden und zum anderen muß die Sperrschichtkapazität über den Lastwiderstand aufgeladen werden. Daher darf der Lastwiderstand nicht zu groß sein, damit die vorgegebene Sperrschichtkapazität von einigen 10 pF schnell genug aufgeladen werden kann. Außerdem muß die Zahl der freien Ladungsträger in der Sperrschicht möglichst niedrig gehalten werden, zumindest muß dafür gesorgt werden, daß kein Betrieb der Sperrschicht im Sättigungsbereich vorkommt.

Denn bei einer Sperrschicht im Sättigungsbereich findet eine Überflutung der Sperrschicht mit freien Ladungsträgern statt. Die Leitfähigkeit der Halbleiterschaltelemente ist zwar sehr gut, aber beim Umschalten in den gesperrten Zustand tritt zusätzlich eine Freiwerde-Zeit auf, die bei Kleinleistungs-Transistoren einige 10 μs betragen kann.

An die integrierten Bausteine, die in einer erfindungsgemäßen Verzögerungseinheit verwendet werden, sind die gleichen Anforderungen zu stellen wie an die diskreten Komponenten. Bei dem Aufbau der Schaltung werden in den kritischen Baugruppen ECL-IC's (Serie 10000) und ECL-Komparatoren (High-Speed-Komparator SP 9685) verwendet, da die anderen Serien von integrierten Bausteinen nicht schnell genug sind.

Der Aufbau der Schaltung soll niederinduktiv ohne größere Störungen und Reflexionen sein. Um dies zu erreichen, können eine Seite der Platine weitgehend als Masse-Seite ausgebildet und neben die Signalbahnen noch Masse-Bahnen gelegt werden. Dadurch werden kleine Induktivitäten und bei entsprechender Breite der Leiterbahnen (Mikrostrip) eine definierte Impedanz erzielt werden. Einzelheiten hinsichtlich von ECL-Bausteinen lassen sich dem Buch « MECL High-Speed-Integrated-Circuits », Motorola Semiconductors (1978) entnehmen.

Die Steuerung einer erfindungsgemäßen Verzögerungseinheit übernimmt ein Mikroprozessorsystem. Im Ausführungsbeispeil wird ein Mehrkartensystem mit kommerziell gelieferten Karten (MPC) gewählt. Dazu gehört einmal eine MPU-Karte MPC 103 mit einem Mikroprozessor 6802 (Motorola), mit einem 16 kByte EPROM und mit einem 2 kByte RAM. Weiter gehören dazu zwei Stück 8 kByte RAM-Karten MPC 112. Als Eingabe-Medium kann eine Fernschreibmaschine Teletype Model 43 dienen, die über eine Seriell-Schnittstelle MPADA 04A (TTY-Interface) angeschlossen werden kann. Dabei ist über die Tastatur der Fernschreibmaschine eine Eingabe und über das Druckwerk eine Ausgabe möglich. Als weiteres Ausgabe-Medium kann ein 9 Zoll-Monitor dienen, der über eine Karte MPC 402 (Video-Interface) angeschlossen werden kann. Als weiteres Ausgabe-Medium kann ein Magnetbandgerät Typ DCD 1 (3 M-Company) dienen, das über eine 8 Bit-Parallel-Interface-Karte MPC 250 angeschlossen werden kann. Als weiteres Ausgabe-Medium kann ein Plotter Watanabe Digiplot dienen, der über eine weitere Interface-Karte MPC 250 angeschlossen werden kann.

Dieses Mikroprozessorsystem steuert eine erfindungsgemäße Verzögerungseinheit über einen MPU-Bus 11 mit Hilfe der Steuersignale 12, 13. Die Steuersignale 12 gelangen zum Digital-/Analog-Wandler 8 für die Referenzspannung. Dieser Digital-/Analog-Wandler 8 besteht aus einer Karte MPC 124. Die Steuersignale 13 gelangen zum Vorwahlzähler 4, der im Ausführungsbeispiel nach Fig. 3 im wesentlichen aus dem ECL-Zähler Z1 und dem TTL-Zähler Z2 besteht.

In einer sehr einfachen Ausführungsform muß eine Verzögerungseinheit nach der Erfindung nicht notwendig von einem Mikroprozessorsystem gesteuert werden. Grundsätzlich genügt zur Steuerung einer Verzögerungseinheit nach der Erfindung irgendeine Vorrichtung, die in definierter Weise die Signale 12, 13 an eine Verzögerungseinheit nach der Erfindung abgeben kann.

Um eine über die gesamte Zeitskala konstante Genauigkeit für die Verzögerungszeit von unter 1 ns zu erzielen und um eine Rechnersteuerung der Verzögerungszeit zu ermöglichen, wird folgendes Prinzip gewählt: Der Verzögerungszeitbereich wird in Schritten durch Zählen eines Signals 14 grob unterteilt. Eine Feinunterteilung des Verzögerungszeitbereiches zwischen jeweils zwei Schritten der Grobunterteilung erfolgt mit Hilfe eines Rampengenerators 6, dessen momentane Amplitude 16 mit einer vorgegebenen Gleichspannung 15 verglichen wird.

Der 8 Bit-Digital-/Analog-Wandler 8 ermöglicht bei der Feinaufteilung eines Zeitbereiches von 20 ns eine minimale Auflösung von 0,1 ns. Dies liegt deutlich unter der Auflösung der anderen Komponenten in der Schaltung nach Fig. 3. Bei einer Genauigkeit des Signals 14 von ca. $10^{-5}$ % und bei einer Linearität des Rampengenerators 6 besser als 1 % ist daher eine Genauigkeit von besser 0,5 ns über den gesamten Verzögerungszeitbereich zu erwarten. Der Rampengenerator 6 wird dabei stets mit der gleichen Anstiegszeit betrieben; Umschaltelemente werden dabei nicht benötigt.

Zur Erzeugung des Signals 14 wird ein 50-MHz-Quarzgenerator 5 verwendet. Das Signal 14 wird Fig. 3 von einer Oszillatorschaltung erzeugt, die bei ungefährer Abstimmung des Resonanzkreises auf 50 MHz zuverlässig auf der Oberwelle schwingt. Einzelheiten dieser Schaltung sind in Applikationsberichten für TTL-integrierte Schaltkreise von Texas Instruments zu finden. Die Schaltung zur Erzeugung des Signals 14 weist überdies eine Auskoppelstufe auf. Diese Auskoppelstufe verhindert die Belastung des Schwingkreises und verstärkt die Signalamplitude des Signals 14 auf eine Spannung von ca. 3 $V_{SS}$.

Im Digitalteil der Schaltung nach Fig. 3 werden folgende Komponenten benutzt: SP 9685 High-Speed-Komparatoren 2, 7 jeweils mit Latch (Verriegelung). Die Ausgänge dieser Komparatoren 2, 7 weisen ECL-Pegel auf. Der Komparator 2 wird für die Aufbereitung des Eingangssignals 1 und der Komparator 7 wird für den Vergleich des Rampensignals 16 mit der Referenzspannung 15 benötigt.

Ein ECL-Zähler MC 10136 dient als Zähler Z1. Dieser Zähler Z1 wird als programmierbarer synchroner 4 Bit-Vorwahlzähler bis 100 MHz in der ersten Zählstufe verwendet.

Ein TTL-Zähler 74LS191 dient als Zähler Z2. Dieser Zähler Z2 wird als programmierbarer synchroner 4 Bit-Vorwahlzähler bis 5 MHz in der zweiten Zählstufe verwendet.

Ein ECL-Dual D-Flipflop MC 10231 dient Flipflop FF1. Dieses Flipflop FF1 wird zur Steuerung des Rampengenerators 6 verwendet.

ECL OR-Gatter MC 10103 4 x 2 OR Gate werden als Gatter N1, N2, N3, N4, N7 verwendet. ECL OR-Gatter MC 10109 4/5 OR/NOR Gate werden als Gatter N5, N6 verwendet.

Bei einem positiven Spannungssprung des Eingangssignals 1 wird der Ausgang Q des Komparators 2 auf den logischen Wert 1 gelegt. Über das Gatter N1 wird der Komparator 2 verriegelt, so daß die Ausgangssignale des Komparators 2 auch nach Abklingen des positiven Spannungssprungs des Eingangssignals 1 erhalten bleiben. Somit liegt am D-Eingang des Flipflops FF1 eine logische «1» an. Bei der nächsten positiven Flanke des Signals 14 wird auch der Ausgang Q des Flipflops FF1 auf den logischen Wert «1» gelegt. Gleichzeitig erhält der Zähler Z1 von diesem Flipflop FF1 ein Carry In-Signal und beginnt ab der zweiten positiven Flanke des Signals 14 vom eingestellten Zählerstand nach Null zu zählen. Der Zähler Z1 wird also erst dann freigegeben, wenn das Flipflop FF1 bereits geschaltet ist. Der Zähler Z1 zählt also im Ausführungsbeispiel nach Fig. 3 erst den zweiten Impuls des Signals 14 nach Auftreten der positiven Flanke des Eingangssignals 1. Dieses Schaltungsprinzip verhindert bei fehlender Korrelation zwischen Eingangssignal 1 und Signal 14, daß unter gewissen Umständen eine der beiden integrierten Schaltungen FF1, Z1 bereits schaltet, daß die andere dieser beiden integrierten Schaltungen FF1, Z1 jedoch erst beim nächsten Taktimpuls schaltet. Da der Zähler Z1 bei einer Schaltung nach Fig. 3, also im Gegensatz zum Signaldiagramm nach Fig. 2, erst den zweiten Impuls des Signals 14 zählt, muß der Zählerstand, der über die Signale 13 an den Vorwahlzähler 4 angelegt wird, bei einer Schaltung nach Fig. 3 um 1 niedriger sein im Vergleich zu einer Schaltung, bei der das Signaldiagramm nach Fig. 2 verwirklicht ist.

Der Zähler Z1 zählt die vier niederwertigen Bits des über die Signale 13 vorgegebenen Zählerstandes, der Zähler Z2 zählt über die Konverter K1, K11 die vier höherwertigen Bits des über die Signale 13 vorgegebenen Zählerstandes. Als Konverter K1-K12 werden Konverter ECL-TTL MC 10125 bzw. TTL-ECL MC 10124 verwendet.

Beim Zählerstand «00» sind die Ausgänge Q0-Q3 des Zählers Z1 jeweils auf den logischen Wert «0» gelegt, der Min/Max-Ausgang des Zählers Z2 weist in diesem Fall den logischen Wert «1» auf. Somit wird in diesem Fall auch der invertierte Ausgang des Gatters N5 auf den logischen Wert «1» gelegt, weil alle Eingänge des Gatters N5 in diesem Fall jeweils den logischen Wert «0» aufweisen, und infolgedessen wird auch das Flipflop FF1 zurückgesetzt. Das Ausgangssignal Q des Flipflops FF1 und das invertierte Ausgangssignal des Komparators 2 werden im Gatter N2 zum Steuersignal 17 des Rampengenerators 6 zusammengefügt. Gleichzeitig mit dem Reset des Flipflops FF1 wird ein weiteres Flipflop FF2 gesetzt und dadurch das Clock-Signal des Flipflops FF1 blockiert. Dadurch wird verhindert, daß das Signal 14 ein weiteres Umschalten des Flipflops FF1 veranlassen kann.

Für Verzögerungszeiten unter 40 ns wird über die Signale 13 am Eingang X1 des Konverters K12 eine logische «1» angelegt und zugleich der Zählerstand auf «00» gesetzt. Somit werden über das Gatter N3 und das Flipflop FF2 das Flipflop FF1 gesperrt und die Zähler Z1, Z2 passiviert. Das Eingangssignal 1 wird in diesem Fall für Verzögerungszeiten unter 40 ns, also ohne zeitliche Unterbrechung, über das Gatter N2 direkt zum Rampengenerator 6 geleitet.

Das Anlegen eines jeden neuen Zählerstandes an die Eingänge der Zähler Z1, Z2 geschieht vom Mikroprozessor aus zwischen dem Eintreffen eines Eingangssignals 1 am Eingang der Verzögerungseinheit, sofern dieses Eingangssignal 1 den Ausgang Q des Komparators 2 auf den logischen Wert «1» schaltet und somit eine Verriegelung des Ausgangssignals dieses Komparators 2 veranlaßt, und dem Eintreffen eines weiteren Eingangssignals 1, das nach Abgabe eines verzögerten Ausgangssignals 9 von der Verzögerungseinheit als nächstes Eingangssignal 1 wiederum den Ausgang Q des Komparators 2 auf den logischen Wert «1» schalten kann. Dieses Anlegen eines neuen Zählerstandes an die Eingänge der Zähler Z1, Z2 wird vom invertierten Ausgang des Komparators 2 über einen invertierenden Konverter K3 über das Trigger-Signal X5 veranlaßt. Das Trigger-Signal X5 löst dabei im Mikroprozessorsystem den Ablauf des Anlegens des neuen Zählerstandes an die Dateneingänge d0, d7, der Zähler Z1, Z2 aus. Die Eingänge T1, T2 weisen stets jeweils den logischen Wert «0» auf.

Das Signal 10, das dem invertierten verzögerten Ausgangssignal 9 entspricht, bildet zusammen mit dem Signal T1 die beiden Eingänge des Gatters N7. Solange das Signal 10 den logischen Wert «1» aufweist, solange also das verzögerte Ausgangssignal 9 am Ausgang des Komparators 7 noch nicht erschienen ist, kann der an die Eingänge d0, d7 der Zähler Z1, Z2 angelegte neue Zählerstand nicht in diese Zähler übernommen werden. Sobald das Signal 10 den logischen Wert «0» annimmt, d. h. sobald das verzögerte Ausgangssignal 9 am Ausgang des Komparators 7 erscheint, weisen beide Eingänge des Gatters N7 den logischen Wert «0» auf. In diesem Fall werden die beiden Eingänge S1, S2 des Zählers Z1 auf den logischen Wert «0» gesetzt. Dieses Setzen der beiden Eingänge S1, S2 des Zählers Z1 hat fünf Konsequenzen:

1. werden die vier niederwertigen Bits d0, d3 des neuen Zählerstandes in den Zähler Z1 übernommen,

2. wird über das Gatter N6 und über den Konverter K2 der Zähler Z2 angesteuert und werden die vier höherwertigen Bits d4, d7 des neuen Zählerstandes in den Zähler Z2 eingelesen,

3. wird über den invertierten Ausgang des Gatters N6 das Flipflop FF2 zurückgesetzt,

4. werden über den invertierten Ausgang des Gatters N6 ebenso die Latch-Kreise der Komparatoren 2, 7 über die Gatter N1, N4 zurückgesetzt,

5. wird der Ladekondensator C1 durch Transistor T4 im Rampengenerator 6 entladen.

Unmittelbar nach Abklingen des verzögerten Ausgangssignals 9 weist das Signal 10 wieder den logischen Wert « 1 » auf. Dies bedeutet, daß nunmehr der Eingang S1 des Zählers Z1 den logischen Wert « 1 » aufweist, während der Eingang S2 des Zählers Z1 immer noch den Wert « 0 » aufweist. Damit ist im Zähler Z1 der Betriebsmodus « Count down » gesetzt. Vom nächsten positiven Spannungssprung des Eingangssignals 1 wird sodann das nächste verzögerte Ausgangssignal 9 ausgelöst.

Die Erfindung ermöglicht ein automatisches, rechnerunabhängiges Laden eines neuen Zählerstandes in den Vorwahlzähler 4 und ein automatisches, rechnerunabhängiges Bereitstellen der Verzögerungseinheit dafür, daß ein neu eintreffendes Eingangssignal 1 ein weiteres verzögertes Ausgangssignal 9 auslöst. Damit werden hohe Repetitionsraten des gesamten Meßsystems ermöglicht. In der Elektronenstrahlmeßtechnik ist es beispielsweise notwendig, daß ein Zyklus eines periodischen Spannungsverlaufes an einem Schaltungsknoten in einem Meßobjekt in möglichst kurzer Zeit vollständig aufgezeichnet wird. Eine solche Aufzeichnung eines Zyklus eines periodischen Spannungsverlaufes geschieht überlicherweise mit Hilfe des Sampling-Prinzips. Um den Zyklus eines periodischen Signalverlaufes zeitaufgelöst aufnehmen zu können, wird dabei die Phase, mit der die Elektronensonde bezüglich des Zyklus des periodischen Signalverlaufes auf eines Schaltungsknoten auftrifft, über die verschiedenen Meßimpulse hinweg variiert.

Die Elektronensonde wird also periodisch mit der Periode des aufzuzeichnenden Spannungsverlaufes am Schaltungsknoten gepulst, jeder Puls der elektronensonde weist dabei bezüglich des Zyklus des aufzuzeichnenden Spannungsverlaufes eine andere Phase auf. Wenn die Phase der gepulsten Elketronensonde bezüglich des aufzuzeichnenden periodischen Signalverlaufes über den gesamten Zyklus dieses aufzuzeichnenden Signalverlaufes hinweg verschoben worden ist, so ist über die Meßsignalverarbeitung ein ganzer Zyklus des zu untersuchenden periodischen Signalverlaufes aufgezeichnet worden. Das Sampling-Prinzip in der Elektronenstrahlmeßtechnik ist beispielsweise in der US-Patentschrift 4 220 853 beschrieben.

Die Meßsignalverarbeitung kann bei einer Messung nach dem Sampling-Prinzip mit Hilfe eines Zeitfensters (gate) erfolgen. Die Zeitauflösung einer Messung wird dann nur von der Torzeit des Zeitfensters und von der Genauigkeit der Zeitpunkte, zu denen die gepulste Elektronensonde mit einer jeweils definierten Verzögerungszeit (Phase) auf einen Schaltungsknoten auftrifft, bestimmt. Dabei kommt es nicht so sehr auf die absolute Genauigkeit der Verzögerungszeiten als vielmehr auf die Reproduzierbarkeit (Jitter) dieser Verzögerungszeiten an. Synchron mit der gepulsten Elektronensonde wird über das verzögerte Ausgangssignal 9 auch das Gate der Meßsignalverarbeitung angesteuert.

Wenn beispielsweise in der Elektronenstrahlmeßtechnik die Verzögerungszeiten (Phasen) der gepulsten Elektronensonde bezüglich eines zu untersuchenden periodischen Spannungsverlaufes immer in derselben definierten Weise variiert werden, können die Signale 12, 13 auch von einem relativ einfach ausgestalteten Zähler abgegeben werden. In einem solchen Fall wird nicht unbedingt ein aufwendiges Mikroprozessorsystem benötigt.

Bei einer Verzögerungseinheit nach der Erfindung durchläuft das Eingangssignal 1 vom Eingang bis zum Rampengenerator 6 lediglich zwei Bauteile, nämlich den Komparator 2 und das Gatter N2. Dadurch wird eine sehr kurze Verzögerungszeit bis zum Start des Rampengenerators 6 von ca. 4 ns erreicht.

Der Rampengenerator 6 besteht aus folgenden Baugruppen :
— einer Konstantstromquelle mit der integrierten Schaltung IC1 und dem Transistor T5,
— einem Umschalter mit den Transistoren T1, T2,
— einer Entladestufe mit dem Transistor T4,
— einer Auskoppelstufe mit dem Transistor T3,
— einer Aufbereitung der Referenzspannung mit dem integrierten Schaltkreis IC2 und mit einer Vergleichsstufe mit dem Komparator 7 und dem Gatter N4.

Abhängig von den Spannungen an den Basiselektroden der Transistoren T1, T2 fließt der Konstantstrom von Kollektor des Transistors T5 entweder in den Ladekondensator C1 oder über den Widerstand R3 ab. Die Spannung an der Basis des Transistors T1 beträgt stets ca. — 7,5 Volt. Über die Widerstande R5, R6, R7 wird das Steuersignal 17 für den Rampengenerator 6 auf den richtigen Pegel gebracht : Die logische « 1 » entspricht einer Spannung — 7,1 Volt und die logische « 0 » entspricht einer Spannung — 7,9 Volt. Bei einer logischen « 0 » am Ausgang des Gatters N2 wird also der Ladekondensator C1 geladen. Bei einer logischen « 1 » des Steuersignals 17′ hält der Ladekondensator C1 den momentanen Spannungswert. Das Rampensignal 16 gelangt über den Source-Folger T3 an den invertierenden Eingang des Komparators 7. Das Rampensignal 16 kann dort einen Wert zwischen + 2,5 Volt und — 5,7 Volt einnehmen. Dabei beträgt die Spannung U, die das Rampensignal 16 zur Zeit T einnimmt, 0,6 Volt. Die DC-Vergleichsspannung 15 muß daher also für Verzögerungszeiten größer als 20 ns Werte zwischen 0,6 Volt und — 2,0 Volt und für Verzögerungszeiten kleiner als 20 ns Werte zwischen 2,5 Volt und 0,6 Volt annehmen. Um den Abgleichvorgang zu vereinfachen, wird dies folgendermaßen realisiert : Für Verzögerungszeiten kleiner als 20 ns werden am Eingang des Digital/Analog-Wandlers 8 die Zahlen 00-7F und für Verzögerungszeiten größer als 20 ns die Zahlen 80-FF verwendet. Dadurch wird das Signal X1 für Verzögerungszeiten kleiner als 40 ns nicht mehr benötigt. Dem Ausgangssignal 15 des Digital-/Analog-Wandlers 8 wird eine Konstantspannung zur Nullpunkteinstellung aufaddiert. Dabei kann man über das Potentiometer P1 den Konstantstrom, über das Potentiometer P3 den Nullpunkt der Referenzspannung 15 und über das Potentiometer P4 die Verstärkung der Referenzspannung 15 einstellen.

Der Komparator 7 vergleicht die Rampenspannung 16 mit der Referenzspannung 15 und liefert einen ECL-Spannungssprung als verzögertes Ausgangssignal 9.

Über einen Konverter K10 kann ein TTL-Signal als Gate-Signal zu einer Meßsignalverarbeitungseinrichtung gelangen.

Sofern ein ausreichend frequenzstabiles Eingangssignal 1 vorliegt, kann dieses Eingangssignal 1 mit dem Signal 14 synchronisiert werden. Eine solche Synchronisation ermöglicht es, daß vom Eingangssignal 1 direkt der Ablauf des Zählvorgangs im Vorwahlzähler 4 ausgelöst wird und daß erst anschließend der Rampengenerator 6 ohne zeitliche Unterbrechung solange angesteuert wird, bis das Rampensignal 16 den Wert der Referenzspannung 15 erreicht hat.

**Patentanspruch**

Verzögerungseinheit zur Erzeugung eines gegenüber einem Eingangssignal (1) um eine definierte Verzögerungszeit $(T + t_4)$ verzögerten Ausgangssignals (9), bestehend aus
— einem Komparator (2), auf dessen einen Eingang das Eingangssignal (1) und auf dessen zweiten Eingang eine Triggerschwelle (3) anliegt,
— einem Vorwahlzähler (4) zur schrittweisen Einstellung der Verzögerungszeit $(T + t_4)$, wobei ein Ausgangssignal des Komparators (2) an einem Freigabeeingang des Vorwahlzählers (4) anliegt und ein Zählerstand an diesem Vorwahlzähler (4) von einem Rechner über einen Bus (11) und weiter über Signalleitungen (13) vorgegeben wird,
— einem frequenzstabilen Signalgeber (5) zur Abgabe von Zählimpulsen (14) an den Vorwahlzähler (4),
— einem Rampensignalgeber (6) zur Feinunterteilung der Verzögerungszeit $(T + t_4)$, wobei ein Ausgangssignal des Komparators (2) und ein Ausgangssignal des Vorwahlzählers (4) zum Steuersignal des Rampensignalgebers (6) zusammengefügt werden, und ein Ausgangssignal (16) des Rampensignalgebers (6) am Ausgang desselbigen erzeugt wird, wobei der Ablauf des Ausgangssignals (16) des Rampensignalgebers (6) mit der ersten positiven Flanke der Zählimpulse (14) an den Vorwahlzähler (4) nach Eintreffen des Eingangssignals (1) unterbrochen und der Vorwahlzähler (4) freigegeben wird,
— einer Einrichtung (8) zur Erzeugung eines Referenzsignals (15) für das Ausgangssignal (16) des Rampensignalgebers (6), wobei die Größe des Referenzsignals (15) von dem Rechner über den Bus (11) und weitere Signalleitungen (12) an die Einrichtung (8) vorgegeben werden kann,
— einem weiteren Komparator (7), in dem das Ausgangssignal (16) des Rampensignalgeberes (6) mit dem Referenzsignal (15) verglichen wird und der an seinem Ausgang das verzögerte Ausgangsignal (9) abgibt,
— und einer weiteren Einrichtung (10) zur Rückführung des verzögerten Ausgangssignals am Ausgang des weiteren Komparators (7) zum Vorwahlzähler (4) zum automatischen, rechnerunabhängigen Laden eines neuen Zählerstandes in den Vorwahlzähler (4).

**Claim**

Delay unit for producing an output signal (9) which is delayed by a defined delay period $(T + t_4)$ compared with an input signal (1), consisting of
— a comparator (2), at one input of which the input signal (1) is present and at the second input of which a trigger threshold (3) is present,
— a preselection counter (4) for setting the delay period $(T + t_4)$ step by step, an output signal of the comparator (2) being present at an enable input of the preselection counter (4) and a count being predetermined at this preselection counter (4) by a computer via a bus (11) and further via signal lines (13),
— a constant-frequency signal generator (5) for emitting counting pulses (14) to the preselection counter (4),
— a ramp signal generator (6) for finely dividing the delay period $(T + t_4)$, an output signal of the comparator (2) and an output signal of the preselection counter (4) being combined to form the control signal of the ramp signal generator (6) and an output signal (16) of the ramp signal generator (6) being generated at the output of the latter, the sequence of the output signal (16) of the ramp signal generator (6) being interrupted with the first positive edge of the counting pulses (14) to the preselection counter (4) after arrival of the input signal (1) and the preselection counter (4) being enabled,
— a device (8) for generating a reference signal (15) for the output signal (16) of the ramp signal generator (6), in which arrangement the magnitude of the reference signal (15) can be predetermined by the computer via the bus (11) and further signal lines (12) to the device (8),
— a further comparator (7) in which the output signal (16) of the ramp signal generator (6) is compared with the reference signal (15) and which emits the delayed output signal (9) at its output,
— and a further device (10) for feeding back the delayed output signal at the output of the further comparator (7) to the preselection counter (4) for automatically loading a new count into the preselection counter (4) independently of the computer.

**Revendication**

Unité de retard servant à produire un signal de sortie (9) retardé d'un temps de retard défini $(T + t_4)$ par rapport à un signal d'entrée (1), et constituée par

— un comparateur (2), à une entrée duquel est appliqué le signal d'entrée (1) et à la seconde entrée duquel est appliqué un seuil de déclenchement (3),

— un compteur de présélection (4) servant à régler pas-à-pas le temps de retard $(T + t_4)$, un signal de sortie comparateur (2) étant appliqué à l'entrée d'autorisation du compteur de présélection (4) et un état de comptage présent dans ce compteur de présélection (4) étant retransmis par un ordinateur par l'intermédiaire d'un bus (11) et en outre par l'intermédiaire de lignes (13) de transmission de signaux,

— un générateur de signaux (5) à fréquence stable, servant à envoyer des impulsions de comptage (14) au compteur de présélection (4),

— un générateur (6) de signaux en forme de rampe servant à réaliser une subdivision fine du temps de retard $(T + t_4)$, auquel cas un signal de sortie du comparateur (2) et un signal de sortie du compteur de présélection (4) sont réunis pour former le signal de commande du générateur (6) de signaux en forme de rampe, et un signal de sortie (16) du générateur (6) de signaux en forme de rampe est produit à la sortie de ce générateur, et la transmission du signal de sortie (16) du générateur (6) de signaux en forme de rampe est interrompue au moyen du premier flanc positif des impulsions de sélection (14) arrivant dans le compteur de sélection (4), après l'apparition du signal d'entrée (1) et le compteur de présélection (4) est libéré,

— un dispositif (8) servant à produire un signal de référence (15) pour le signal de sortie (16) du générateur (6) de signaux en forme de rampe, l'amplitude du signal de référence (15) pouvant être transmise par l'ordinateur par l'intermédiaire du bus (11) et d'autres lignes (12) de transmission de signaux au dispositif (8),

— un autre comparateur (7), dans lequel le signal de sortie (16) du générateur (6) de signaux en forme de rampe est comparé au signal de référence (15) et qui délivre, sur sa sortie, le signal de sortie retardé (9),

— et un autre dispositif (10) servant à renvoyer le signal de sortie retardé, présent à la sortie de l'autre comparateur (16), au compteur de présélection (4) pour réaliser le chargement automatique, indépendant de l'ordinateur, d'un nouvel état de comptage dans le compteur de présélection (4).

# FIG 1

# FIG 2

FIG 3a

FIG 3b

EP 0 150 325 B1